# EUROPEAN PATENT SPECIFICATION

(11) **EP 3 818 599 B1**
(45) Date of publication and mention of the grant of the patent: **02.02.2022**
(21) Application number: 19728010.0
(22) Date of filing: 29.05.2019
(51) Int. Cl.: H01R 13/713, H01R 31/06, H01R 13/66

(54) **ADAPTER DEVICE WITH HEAT PROTECTION SWITCH**
ADAPTERVORRICHTUNG MIT WÄRMESCHUTZSCHALTER
DISPOSITIF ADAPTATEUR À COMMUTATEUR DE PROTECTION THERMIQUE

(30) Priority: 02.07.2018 SE 1850826
(43) Date of publication of application: 12.05.2021
(73) Proprietor: JonDeTech Sensors AB (publ), 114 28 Stockholm (SE)
(72) Inventor: KVIST, Niklas, 139 36 Värmdö (SE)
(74) Representative: Noréns Patentbyrå AB
(86) International application number: PCT/EP2019/063949
(87) International publication number: WO 2020/007538

(56) References cited:
- EP-A2- 2 701 244
- TW-B- I 594 542
- US-A1- 2001 012 732
- US-A1- 2012 180 839
- US-A1- 2014 342 590

## Description

### Field of the invention

This invention relates to an adapter with a heat monitoring ability, which can be conveniently attached to a mobile phone charger.

### Background

Electricity transformers are used for charging laptops, tablet computers and in particular mobile phones. For examples, in a family home, several mobile phones can be charged during night time. Such transformers a typically referred to as "chargers"

Such chargers may be overheated. In particular, poorly manufactured, low-cost chargers for mobile phones may be dangerous since they can cause fires. TW I 594 542 B discloses an example of a charging system including a temperature detector with a switch.US 2001/012732 A1 discloses an adaptor device comprising a heat sensor and a switch, according to the preamble of claim 1. Other teachings regarding heat sensor and safety systems can be found in documents EP2701244 A2, US 2012/180839 A1, US 2014/342590 A1.

There is thus a need for a convenient, low cost device for monitoring chargers.

### Summary of the invention

Z The problem set above is solved by the invention according to claim 1.

In a first aspect of the invention there is provided an adaptor device comprising a housing, a female electrical connector, a male electrical connector adapted to couple to a female electrical connector of the same type as comprised in the adaptor device, where parts of the housing form a part of the female electrical connector and a part of the male electrical connector, the device further comprising at least two leads in the housing from the male to the female connector such that the device can provide electricity to the female connector, and thereby to a male connector of a second device coupled to the female connector, the adapter device further comprising a switch that can switch off the electricity provided in the leads, the device further comprising a heat sensing device, said heat sensing device comprising an IR sensor arranged in a space in the housing, said housing having an aperture for allowing IR radiation from the male connector of the second device to reach the IR sensor in the space of the housing, where the aperture is arranged in the female connector such that the aperture, when a male connector of a second device is coupled to the female connector of the adaptor device, is in close proximity to said male connector, where the heat sensing device is arranged to cause the switch to switch off the current to the female connector when the detected temperature rises above a threshold temperature.

The female connector according to the invention has two receptacles for receiving pins of a male member and the IR sensor, or the aperture for the IR sensor, is arranged between the receptacles of the female connectors of the adaptor device. This has the advantage that it is likely that the second device comes in the field of view of the IR sensor, for example when a the male member of the second device is formed as an Europlug or similar. The female connector may be arranged to receive the male connector from one direction and the IR sensor is arranged to detect heat from the same direction. This has the advantage that the IR sensor "observes" the second device.

The heat sensing device may be powered by the leads. The heat sensing device may be powered by the leads irrespectively of the switch.

The IR sensor may comprise a thermopile. The leads of the leads of the thermopile may be approximately parallel to the incoming radiation, and the leads of the thermopile may be embedded in a matrix.

In a second aspect of the invention there is provided an assembly comprising a) an adaptor device according to the first aspect of the invention 7, b) a charger comprising a male connector, where the male connector and the transformer of the charger is provided in the same housing, where the male connector of the charger is inserted into the female connector of the adaptor device such that the housing of the charger is in close proximity to the IR sensor or an aperture for the IR sensor of the adaptor device.

In a third aspect of the invention there is provided a method comprising the steps of a) connecting the male connector of an adaptor device according to the first aspect of the invention to a power outlet, b) connecting a male connector of a charger where the male connector and the transformer of the charger is provided in the same housing, to the female connector of the adaptor device such that the housing of the charger is in close proximity to the IR sensor or an aperture for the IR sensor, of the adaptor device where steps a) and b) can be carried out in any order.

### Brief description of drawings

The accompanying drawings form a part of the specification and schematically illustrate preferred embodiments of the invention and serve to illustrate the principles of the invention. Reference numbers are the same throughout the description.
Figs. 1 and 2 are schematic drawings of a adapter device, a charger and a power socket.
Fig. 3 is a schematic drawing of an adapter device.
Fig. 4 is a schematic drawing of an adapter device and a charger.
Fig. 5 is a schematic drawing of an adapter device with an aperture.
Fig. 6 is a schematic drawing of an adapter device.
Figs 7-8 are schematic side views and front views of a thermopile.
Figs. 9-10 are drawings of an adapter and a charger.

### Detailed description

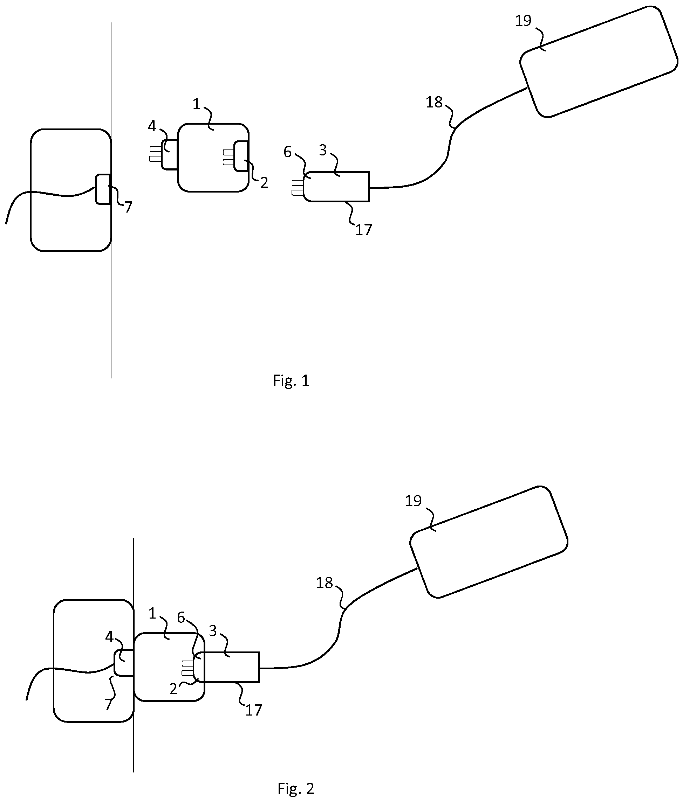

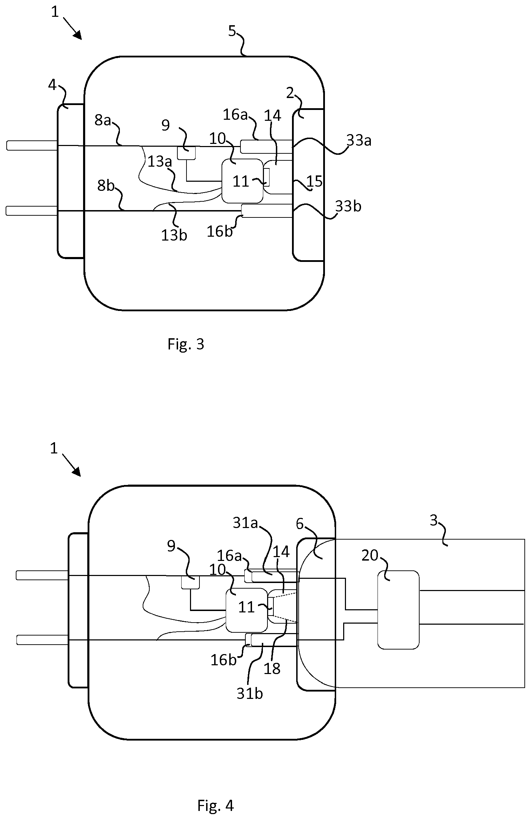

With reference to Figs 1-6, the adaptor device 1 of the invention has a female connector 2 that intended to be used together with a second device 3, preferably a charger 3 of the often-used type that is integrated with a male connector 6 in the same housing 17. When coupled to a female connector 2 the housing 17 of the charger 3 will be in close proximity to the female connector 2.

The charger 3 is preferably a charger for a mobile phone 19 or a tablet computer. The charger 3 is preferably of the type where the transformer 20 and the male connector 6 is provided in the same housing 17. Such chargers 3 are convenient and frequently used. They often have a port 34, such as USB port 34 for attaching a charging cord 18 to for example a mobile phone 19. Charging cord 18 may also be permanently attached to charger 3. The transformer 20 of the charger 3 is preferably in close proximity to the male connector 6. The distance between the outer tip of the pins 31 of the male member 6 and the transformer 20 may preferably be less than 15 cm, more preferably less than 12 cm, even more preferably less than 10 cm, and most preferably less than 8 cm.

The adaptor device 1 has an outer housing 5 and a male connector 4 for coupling to a female electrical connector 7, such as a for example a wall socket or the socket of a power strip. The female electrical connector is referred to as socket 7. The male connector 4 is adapted to couple to a female connector of the same type that is comprised in the adaptor device 1, i.e. female connector 2. Generally, coupling between socket 7 and male connector 4 is reversible, as is coupling between female connector 2 of adaptor device 1 and male member 6 of second device 3.

A part of outer housing 5 forms a part of the female connector 2 and the male connector 4. Accordingly, parts the female connector 2 and the male connector 4 are arranged on the outside of the housing 5 or are parts of the housing 5. Typically surfaces of the female connector 2 forms a part of housing 5. Typically housing 5 will provide openings 33 for the pins 31 of male connector 6 as a part of female connector 2. Furthermore, non-conducting parts of male connector 4 forms a part of housing 5.

The connection direction of the male 4 and the female connector 2 is preferably the same such that the male connector 4 is pushed into the socket 7 in the same direction as the male connector 6 of the second device 3 is pushed into the female connector 2. The female connector 2 and the male connector 4 of the adaptor device 1 may be arranged along the same axis.

The device 1 further comprises at least two leads 8a 8b in the housing 5 from the male connector 4 to the female connector 2 such that the device 1 can provide electricity to the female connector 2, and thereby to a male connector 6 of second device 3 reversibly coupled to the female connector 2 such that electricity can be provided from the socket 7 to the charger 3 via the adaptor device 1. The leads 8a 8b terminate in receptacles 16a 16b arranged to receive the pins 31a 31b of a male member 6 of the second device 3.

Switch 9 in the adapter device 1 can switch off the electricity provided in the leads 8a 8b. Accordingly switch 9 can switch off the electricity provided to the female connector 2 and thereby to second device 3.

The switch 9 is controlled by heat sensing device 10. Heat sensing device 10 comprises IR sensor 11, which may comprise a thermopile 12. The heat sensing device 10 can provide a signal to the switch 9 which causes the switch 9 to break the circuit from the male connector 4 of the adaptor device 1.

The IR sensor 11 is arranged in a space 14 in the housing 5. The IR sensor 11 is able to detect the temperature of the outer surface of the housing of the second device 3, for example the temperature caused by a transformer 20 in second device 3 when second device 3 is a charger. In a preferred embodiment the housing 5 has an aperture 15 for allowing IR radiation 30 from the male member 6 of the second device 3 to reach the IR sensor 11 in the space 14 of the housing 5 in a field of view 18, and where the IR sensor 11 is arranged in the space 14 of the housing 5 to receive IR radiation 30 through the aperture 15 in the field of view 18. The aperture 15 may be a common aperture for the housing 5 and the space 14.

The aperture 15 is arranged in the female connector 2 such that the aperture 15, when a male connector 6 of a second device 3 is coupled to the female connector 2 of the adaptor device 1is in close proximity to said male connector 6, preferably to the outer surface of the male connector 6. Close proximity is preferably less than 5 mm, even more preferably less than 3 mm, and most preferably 1 mm or less.

The aperture 15 provides short response time and provides freedom to place the IR sensor 11 in housing 5.

The aperture 15 does not have a window or filter of a solid material such that IR radiation 30 can pass from the outer surface of male member 6 of the charger 3 into the inner space 14 to the surface 28 of the heat sensor 11 without passing through any solid material and by passing through the air only. Thus, the IR radiation 30 can reach the surface of the thermopile 12, (or when a heat sink 26 is used, the surface of the heat sink 26), directly from the outer surface of the charger 3 by travelling through air only.

The aperture 15 is not necessary. Hence, the IR sensor may also be covered by outer housing 5. However, an advantage with the aperture 15 is that the response time will be shorter.

The rim of the aperture 15 may be provided with sealing means 32 such as brushes or a gasket to prevent IR seepage from for example ambient temperature or lighting to reach the space 14. This prevents false release of switch 9.

Typically, the female connector 2 has at least two receptacles 16a, 16b for receiving pins 31a, 31b of a male member 6. The IR sensor 11, or the aperture 15 for the IR sensor, is preferably arranged between the openings 33a, 33b in the housing 5 for receptacles. The female connector 2 may have more than two receptacles 16a, 16b, for example an additional receptacle for a connection to earth. Preferably the IR sensor 11 or the aperture 15 for the IR sensor is arranged between the + and - receptacles 16a, 16b. This ensures that the IR sensor or the aperture 15 for the IR sensor is in close proximity to the male member 6 of second device 3.

The heat sensing device 10 is able to, using IR sensor 11, to detect a temperature of the male connector 6, in particular the surface of the male connector 6, inserted in the female connector 2. The heat sensing device 10 is furthermore arranged to cause the switch 9 to switch off the current to the female connector 2 when the detected temperature (i.e. the temperature of the male connector 6 coupled to the female connector 2) rises above a threshold temperature. The threshold should be selected so that fires caused by a malfunctioning second device 3 is avoided. A person skilled in the art can select a suitable threshold temperature. The threshold temperature may be for example 55° C.

The heat sensing device 10 may comprise suitable electric circuitry that may comprise an amplifier, an analogue to digital converter, and a processor that may comprise a memory with firmware. The thermopile 12 may be electrically connected to an amplifier that amplifies the signal from the thermopile 12. The signal from the amplifier may be digitalized by the analogue/digital converter that provides the digitalized signal to the processor. The processor may have firmware that comprises the temperature threshold such that the processor provides a signal to the switch 9 if the detected temperature is above the threshold. The processor may also provide additional functionality such as, for example, resetting the device 1, providing an alarm, or providing a visual indication of release of switch 9, etc.

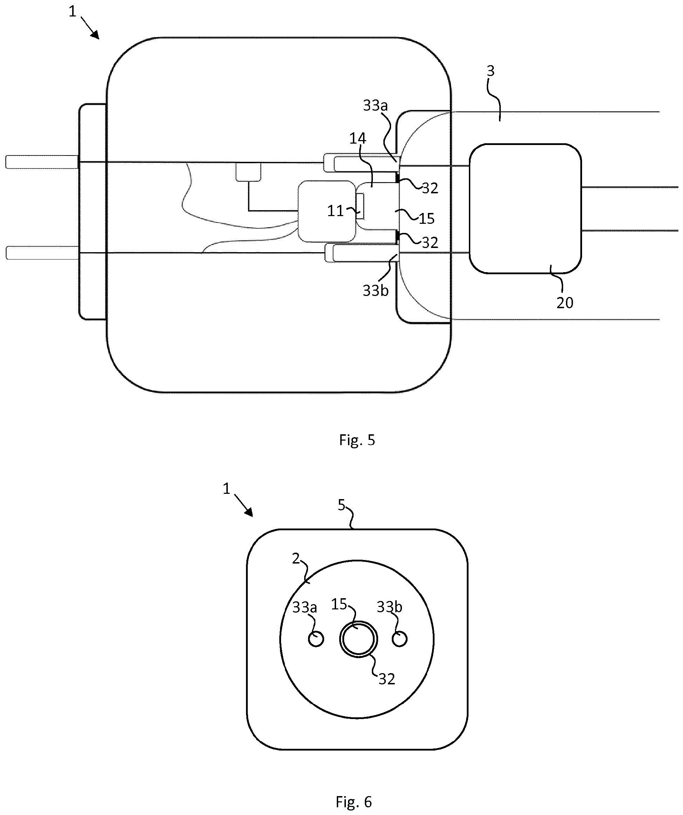

Heat sensing device 10 may obtain power from thermopile 12 but may need additional power for, for example, an amplifier. The heat sensing device 10 may obtain power from the leads 8 trough wires 13a 13b. Heat sensing device 10 may comprise a power transformer to transform the power from the leads 13a 13b to an appropriate voltage. The power is preferably provided upstream of switch 9 so that sensing device 10 can obtain power independently of switch 9, as shown in Fig 5. Alternatively, heat sensing device 10 may be able to "sneak" power from leads 8a 8b by using induction or may be powered by a battery in housing 5.

The female connector 2 may be arranged to receive the male connector 6 from one direction and the IR sensor 11 may arranged to detect heat from the same direction. This ensures that the male connector 6 comes in close proximity to the IR sensor 11. In particular when the male connector 6 is of the Europlug, US or UK type, this ensures that the IR sensor 11 will come in close proximity of the second device 3.

The adaptor device 1 may have a reset button for resetting switch 9. The adaptor device may also comprise a sound alarm for alerting a user if the second device 3 becomes too hot.

The housing 5 may have any suitable shape as long as it can provide parts of female connector 2 and male connector 4. In Figs. 1 to 6 a rectangular housing 3 is shown but housing 5 may have any suitable shape such as oval, triangular, puck-shaped, spherical, etc.

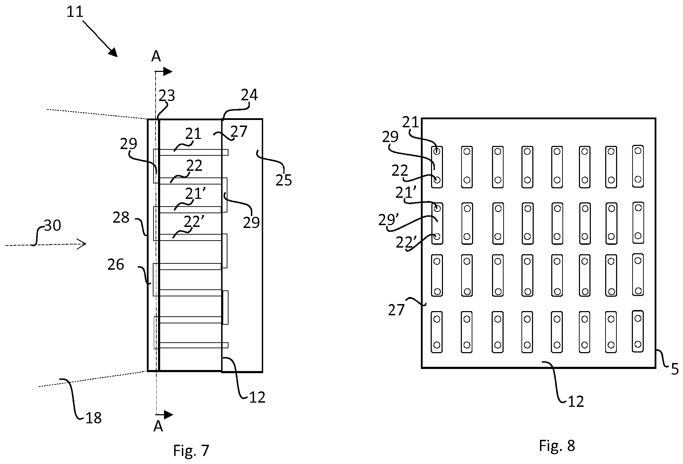

With reference to Figs. 7 and 8, the heat sensor 11 of adapter device sensor 1 may comprise a thermopile 12. A thermopile 12 comprises at least two thermocouples. Each thermocouple consists of a first lead 21 of a first metal and a second lead 22 of a second metal, where the first lead 21 and the second lead 22 have different Seebeck coefficients. Thus, there is at least a first lead 21 that has a first Seebeck coefficient and a second lead 22 that has a second Seebeck coefficient. Examples of suitable pairs of metals include chromel-constantan (type E thermocouple), iron-constantan (type J), chromel-alumel (type K), or copper - nickel. The leads 21, 22 of the thermopile 12 is preferably embedded in matrix 27. When there is a temperature difference between the hot side 23 and the cold side 24 a voltage potential will be generated. Matrix 27 is made from a non-conductive material such as, for example, an epoxy polymer. The material of matrix 27 is preferably a poor conductor of heat and electricity. The material of the matrix 27 can be selected by a person skilled in the art. The leads 21 and 22 may be connected with connectors 29 on the hot side 23 and the cold side 24 of the thermopile 12. The individual thermocouple pairs 21,22 and 21', 22' of the thermopile 12 are coupled to provide a voltage potential that is sufficient to be detected, possibly after amplification. The cold side 24 side of the heat sensor 10 may comprise a cold sink 25. A useful thermopile with this design is described in WO2004098256.

Heat sensor 11 may comprise a heat sink 26 arranged in contact with thermopile 12 such that IR radiation 30 from the second device 3 can be absorbed by the heat sink 26 and transferred to leads 21, 22 of thermopile 12. The heat sink 26 may be a heat absorbing layer. The heat absorbing layer is preferably arranged perpendicular to the direction of the leads 21, 22 of the thermopile 5. The heat sink 26 should be able to absorb heat and conduct heat to thermopile 12. Suitable materials for the heat sink 26 includes materials that efficiently absorb IR radiation, for example a heat absorbing polymer or copper. The heat sink 26 preferably covers the hot side 23 of the thermopile 12, thus being arranged between the aperture 15 and the thermopile 12.

The detection surface 28 of the heat sensor 11 may have any suitable shape. Fig. 8 shows a square configuration of the thermopile 12, but a circular detection area may be preferred.

As seen in the figures, the thermopile 12 is preferably of an axial design, i.e. where the direction of the leads 21,22 are arranged so that they are approximately parallel to main direction of the incoming radiation 30. "approximately parallel" as used in this context comprises an angle of up to 10°, more preferably up to 5°, between the incoming radiation and the leads 21, 22 of the thermopile 12. This arrangement makes it possible to provide a large and scalable detection surface 28. It also makes it possible to embed leads 21, 22 in matrix 27, so that leads 21,22 are protected from physical damage. Matrix 27 also shades the cold side 24 from radiation 18.

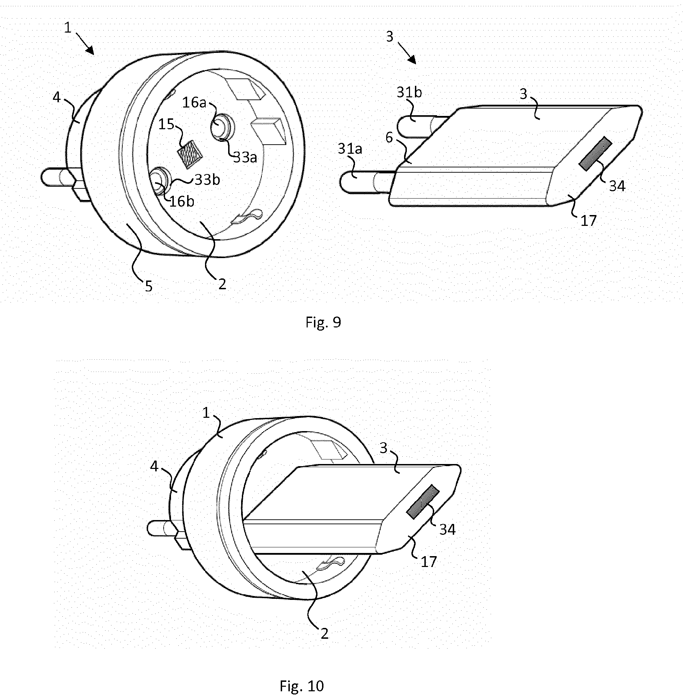

Figs. 9 and 10 shows an embodiment of the adaptor device 1 intended to be used with a charger 3 for the CEE 7/3 ("Schuko") socket typically found large parts of Europe, including Germany and Sweden. The charger 3 in Figs. 9 and 10 have a so called Europlug male connector 6. The Europlug is smaller than other types of male connectors that fit in the European type female 2 shown in Figs 9 and 10.

The aperture 15 is located between the openings 33a, 33b for receptacles 16a, 16b in order to ensure that the heat sensor 11 "observes" the outer surface of charger 3.

While the invention has been described with reference to specific exemplary embodiments, the description is in general only intended to illustrate the inventive concept and should not be taken as limiting the scope of the invention as defined by the appended claims.

## Claims

1. An adaptor (1) device comprising
a housing (5), a female electrical connector (2), a male electrical connector (4) adapted to couple to a female electrical connector of the same type as comprised in the adaptor device, where parts of the housing form a part of the female electrical connector (2) and a part of the male electrical connector (4), the device further comprising at least two leads(8a,8b) in the housing from the male (4) to the female connector (2) such that the device can provide electricity to the female connector (2), and thereby to a male connector of a second device coupled to the female connector (2), the adapter device further comprising a switch (9) that can switch off the electricity provided in the leads (8a, 8b), the device further comprising a heat sensing device (10) arranged to cause the switch (9) to switch off the current to the female connector when the detected temperature rises above a threshold temperature,
**characterized in that** said heat sensing device comprises IR sensor (11) arranged in a space in the housing, said housing having an aperture (15) for allowing IR radiation from the male connector of the second device to reach the IR sensor in the space of the housing, where the aperture (15) is arranged in the female connector (2) such that the aperture, when a male connector of a second device is coupled to the female connector of the adaptor device, is in close proximity to said male connector, wherein the female connector has two receptacles (16a, 16b) for receiving pins of a male member and the IR sensor (11), or the aperture (15) for the IR sensor, is arranged between the receptacles of the female connectors of the adaptor device.

2. The adaptor device according to claim 1 where the female connector (2) is arranged to receive a male connector of a second device from one direction and the IR sensor is arranged to detect heat from the same direction.

3. The device according to any one of claims 1 to 2 where the heat sensing device Z (10) is powered by the leads (8a, 8b).

4. The device according to claim 3 where the heat sensing device is powered by the leads (8a, 8b) irrespectively of the switch (9).

5. The device according to any one of claims 1 to 4 where the IR sensor (11) comprises a thermopile (12).

6. The device according to claim 5 where the leads (21, 22) of the thermopile are approximately parallel to the incoming radiation, and where the leads of the thermopile are embedded in a matrix.

7. An assembly comprising
a. an adaptor device (1) according to any one of claims 1 to 6,
b. a charger (3) comprising a male connector (6), where the male connector and the transformer of the charger is provided in the same housing, where the male connector of the charger is inserted into the female connector (2) of the adaptor device such that the housing of the charger is in close proximity to the IR sensor (11) or an aperture (15) for the IR sensor of the adaptor device.

8. A method comprising the steps of
a. connecting the male connector (4) of an adaptor device (1) according to claim 1 to 6 to a power outlet,
b. connecting a male connector (6) of a charger where the male connector and the transformer of the charger is provided in the same housing, to the female connector (2) of the adaptor device (1) such that the housing of the charger is in close proximity to the IR sensor (11) or an aperture (15) for the IR sensor, of the adaptor device (1) where steps a) and b) can be carried out in any order.

## Patentansprüche

1. Adaptervorrichtung (1), die ein Gehäuse (5), eine elektrische Buchse (2) und einen elektrischen Stecker (4) umfasst, der so beschaffen ist, dass er eine elektrische Buchse desselben Typs, der in der Adaptervorrichtung enthalten ist, koppelt, wobei Teile des Gehäuses einen Teil der elektrischen Buchse (2) und einen Teil des elektrischen Steckers (4) bilden, wobei die Vorrichtung des Weiteren mindestens zwei Leitungen (8a, 8b) in dem Gehäuse von dem Stecker (4) zu der Buchse (2) umfasst, so dass die Vorrichtung der Buchse (2) Strom zuführen kann, und dadurch zu einem Stecker einer zweiten Vorrichtung, die mit der Buchse (2) gekoppelt ist, wobei die Adaptervorrichtung ferner einen Schalter (9) umfasst, der den in den Leitungen (8a, 8b) bereitgestellten Strom abschalten kann, wobei die Vorrichtung ferner eine Wärmeerfassungsvorrichtung (10) umfasst, die so angeordnet ist, dass sie den Schalter (9) veranlasst, den Strom zur Buchse abzuschalten, wenn die erfasste Temperatur über eine Schwellentemperatur ansteigt, **dadurch gekennzeichnet, dass** die Wärmeerfassungsvorrichtung einen IR-Sensor (11) umfasst, der in einem Raum in dem Gehäuse angeordnet ist, wobei das Gehäuse eine Öffnung (15) aufweist, um zu ermöglichen, dass IR-Strahlung von dem Stecker der zweiten Vorrichtung den IR-Sensor in dem Raum des Gehäuses erreicht, wobei die Öffnung (15) in der Buchse (2) so angeordnet ist, dass die Öffnung, wenn ein Stecker einer zweiten Vorrichtung mit der Buchse der Adaptervorrichtung gekoppelt ist, sich in unmittelbarer Nähe des Steckers befindet, wobei die Buchse zwei Aufnahmebereiche (16a, 16b) zur Aufnahme von Stiften eines Steckerelements aufweist und der IR-Sensor (11) oder die Öffnung (15) für den IR-Sensor zwischen den Aufnahmebereichen der Buchsen der Adaptervorrichtung angeordnet ist.

2. Adaptervorrichtung nach Anspruch 1, wobei die Buchse (2) so angeordnet ist, dass sie einen Stecker einer zweiten Vorrichtung aus einer Richtung aufnimmt, und der IR-Sensor so angeordnet ist, dass er Wärme aus der gleichen Richtung erfasst.

3. Vorrichtung nach einem der Ansprüche 1 bis 2, bei der die Wärmeerfassungsvorrichtung (10) über die Leitungen (8a, 8b) mit Strom versorgt wird.

4. Vorrichtung nach Anspruch 3, bei der die Wärmeerfassungsvorrichtung unabhängig vom Schalter (9) über die Leitungen (8a, 8b) mit Strom versorgt wird.

5. Vorrichtung nach einem der Ansprüche 1 bis 4, wobei der IR-Sensor (11) eine Thermosäule (12) umfasst.

6. Vorrichtung nach Anspruch 5, bei der die Leitungen (21, 22) der Thermosäule annähernd parallel zur einfallenden Strahlung verlaufen und bei der die Leitungen der Thermosäule in eine Matrix eingebettet sind.

7. Baugruppe mit
a. einer Adaptervorrichtung (1) nach einem der Ansprüche 1 bis 6,
b. einem Ladegerät (3) mit einem Stecker (6),
wobei der Stecker und der Transformator des Ladegeräts in demselben Gehäuse untergebracht sind,
wobei der Stecker des Ladegeräts so in die Buchse (2) der Adaptervorrichtung eingeführt wird, dass sich das Gehäuse des Ladegeräts in unmittelbarer Nähe des IR-Sensors (11) oder einer Öffnung (15) für den IR-Sensor der Adaptervorrichtung befindet.

8. Verfahren, umfassend die folgenden Schritte
a. Verbinden des Steckers (4) einer Adaptervorrichtung (1) nach einem der Ansprüche 1 bis 6 mit einer Steckdose,
b. Verbinden eines Steckers (6) eines Ladegeräts, wobei der Stecker und der Transformator des Ladegeräts in demselben Gehäuse untergebracht sind, mit der Buchse (2) der Adaptervorrichtung (1), so dass sich das Gehäuse des Ladegeräts in unmittelbarer Nähe des IR-Sensors (11) oder einer Öffnung (15) für den IR-Sensor der Adaptervorrichtung (1) befindet,
wobei die Schritte a) und b) in beliebiger Reihenfolge durchgeführt werden können.

## Revendications

1. Dispositif adaptateur (1) comprenant :
un boîtier (5),
un connecteur électrique femelle (2),
un connecteur électrique mâle (4) conçu pour s'accoupler à un connecteur électrique femelle du même type que celui compris dans le dispositif adaptateur,
dans lequel des parties du boîtier forment une partie du connecteur électrique femelle (2) et une partie du connecteur électrique mâle (4),
le dispositif comprenant en outre au moins deux conducteurs (8a, 8b) dans le boîtier, du connecteur mâle (4) au connecteur femelle (2), de telle sorte que le dispositif puisse fournir de l'électricité au connecteur femelle (2) et ainsi à un connecteur mâle d'un second dispositif accouplé au connecteur femelle (2),
le dispositif adaptateur comprenant en outre un interrupteur (9) qui peut couper l'alimentation électrique des conducteurs (8a, 8b),
le dispositif comprenant en outre un dispositif thermosensible (10) agencé pour amener l'interrupteur (9) à couper l'alimentation en courant du connecteur femelle, lorsque la température détectée s'élève au-dessus d'un seuil de température,
**caractérisé en ce que** ledit dispositif thermosensible comprend un capteur infrarouge (11) placé dans un espace à l'intérieur du boîtier, ledit boîtier présentant une ouverture (15) permettant à un rayonnement infrarouge issu du connecteur mâle du second dispositif d'atteindre le capteur infrarouge dans l'espace du boîtier,
dans lequel l'ouverture (15) est ménagée dans le connecteur femelle (2) de telle sorte que, lorsqu'un connecteur mâle d'un second dispositif est accouplé au connecteur femelle du dispositif adaptateur, l'ouverture soit à proximité immédiate dudit connecteur mâle,
dans lequel le connecteur femelle comporte deux alvéoles (16a, 16b) destinés à recevoir les broches d'un élément mâle et le capteur infrarouge (11) ou l'ouverture (15) destinée au capteur infrarouge est placé(e) entre les alvéoles des connecteurs femelles du dispositif adaptateur.

2. Dispositif adaptateur selon la revendication 1, dans lequel le connecteur femelle (2) est agencé pour recevoir un connecteur mâle d'un second dispositif dans une direction et le capteur infrarouge est agencé pour détecter la chaleur dans la même direction.

3. Dispositif selon l'une quelconque des revendications 1 et 2, dans lequel le dispositif thermosensible (10) est alimenté par les conducteurs (8a, 8b).

4. Dispositif selon la revendication 3, dans lequel le dispositif thermosensible est alimenté par les conducteurs (8a, 8b) indépendamment de l'interrupteur (9).

5. Dispositif selon l'une quelconque des revendications 1 à 4, dans lequel le capteur infrarouge (11) comprend une thermopile (12).

6. Dispositif selon la revendication 5, dans lequel les conducteurs (21, 22) de la thermopile sont sensiblement parallèles au rayonnement incident, et dans lequel les conducteurs de la thermopile sont noyés dans une matrice.

7. Ensemble comprenant :
a. un dispositif adaptateur (1) selon l'une quelconque des revendications 1 à 6,
b. un chargeur (3) comprenant un connecteur mâle (6),
dans lequel le connecteur mâle et le transformateur du chargeur se trouvent dans le même boîtier,
dans lequel le connecteur mâle du chargeur est introduit dans le connecteur femelle (2) du dispositif adaptateur, de telle sorte que le boîtier du chargeur soit à proximité immédiate du capteur infrarouge (11) ou d'une ouverture (15) destinée au capteur infrarouge du dispositif adaptateur.

8. Procédé comprenant les étapes consistant à :
a. connecter le connecteur mâle (4) d'un dispositif adaptateur (1) selon les revendications 1 à 6 à un socle de prise de courant,
b. connecter un connecteur mâle (6) d'un chargeur, dans lequel le connecteur mâle et le transformateur du chargeur se trouvent dans le même boîtier, au connecteur femelle (2) du dispositif adaptateur (1) de telle sorte que le boîtier du chargeur soit à proximité immédiate du capteur infrarouge (11) ou d'une ouverture (15) destinée au capteur infrarouge du dispositif adaptateur (1), dans lequel les étapes a) et b) peuvent être exécutées dans n'importe quel ordre.
